# EUROPEAN PATENT APPLICATION

(11) **EP 1 367 151 A1**
(43) Date of publication of application: **03.12.2003**
(21) Application number: 02701657.5
(22) Date of filing: 28.02.2002
(51) Int. Cl.: C30B 29/48, C30B 29/40

(54) **II-VI GROUP OR III-V GROUP BASED SINGLE CRYSTAL FERROMAGNETIC COMPOUND AND METHOD FOR ADJUSTING ITS FERROMAGNETIC CHARACTERISTICS**

(30) Priority: 02.03.2001 JP 2001059164; 02.03.2001 JP 2001059195; 02.03.2001 JP 2001059303
(71) Applicant: JAPAN SCIENCE AND TECHNOLOGY CORPORATION, Kawaguchi-shi, Saitama 332-0012 (JP)
(72) Inventor: YOSHIDA, Hiroshi, Kawanishi-shi, Hyogo 666-0111 (JP); SATOH, Kazunori, Minoh-shi, Osaka 562-0004 (JP)
(74) Representative: Wagner & Geyer
(86) International application number: JP0201889
(87) International publication number: WO02070793

(57) **Abstract**

Disclosed is a Group II-VI or III-V compound-based single-crystal ferromagnetic material, wherein at least one transition metal selected from the group consisting of V and Cr is substituted for or for the Group II element of a Group II-VI compound selected from the group consisting of ZnTe, ZnSe, ZnS, CdTe, CdSe and CdS, or for the Group III element of a Group III-V compound selected from the group consisting of GsAs, InAs, InP and GaP, to form a mixed crystal. Further, at least one transition metal selected from the group consisting of V, Cr and Mn is substituted for the Group III element of a Group III-V compound selected from the group consisting of GaN, AIN, InN and BN, to form a mixed crystal. Another transition metal element or n-type or p-type dopant is added to adjust ferromagnetic transition temperature or another ferromagnetic characteristic.

## Description

### TECHNICAL FIELD

The present invention relates to a single-crystal ferromagnetic material which is achieved by giving ferromagnetic characteristics to Group II-VI or III-V compounds allowing light to be transmitted therethrough.

### BACKGROUND ART

If a single-crystal ferromagnetic thin film capable of exhibiting high ferromagnetic characteristics while allowing light to be transmitted therethrough is obtained, it will open the way to realizing a magnetooptic-effect-based optical isolator or high-density magnetic storage required for transmitting massive information, and to preparing electromagnetic materials essential for an extremely high level of data transmission in the future. For this purpose, it is desired to provide a light-transmittable material with ferromagnetism.

A Group II-VI compound has a large bandgap (Eg) [ZnS (Eg = 3.8 eV), ZnSe (Eg = 2.7 eV), ZnTe (Eg = 2.4 eV), CdS (Eg = 2.5 eV), CdSe (Eg = 1.7 eV), CdTe (Eg = 1.4 eV)] to exhibit a property allowing transmission of light ranging from the red to ultraviolet wavelength, and its excitons have a high binding energy. Thus, if ferromagnetism is given to this compound, the obtained material can contribute to a major breakthrough in preparing optical devices such as an optical quantum computer utilizing coherent spin dynamics.

While there has been known a material prepared by doping Mn into the Group II-VI compound (Japanese Patent No. 2756501), it is in the antiferromagnetic state or in the antiferromagnetic-spin glass state. In Group II-VI compounds, it has not been reported to achieve a ferromagnetic state having a high ferromagnetic transition temperature (Currie point) of room temperature or more.

A Group III-V compound selected from the group consisting of GaAs, InAs, InP and GaP has a property allowing transmission of light ranging from the red to ultraviolet wavelength. Thus, if a material with ferromagnetism having a high ferromagnetic transition temperature is obtained using this compound, it can also contribute to a major breakthrough in preparing optical devices such as an optical quantum computer utilizing coherent spin dynamics.

While there has been known a material prepared by doping Mn into the Group III-V compound, it has a low ferromagnetic transition temperature (Currie point) of about 100°K. In Group III-V compounds, it has not been reported to achieve a ferromagnetic state having a high Currie point.

A Group III-V nitride has a large bandgap (Eg)[GaN(Eg=3.3eV), AlN(Eg=6.4eV), BN (Eg = 6.4 eV)] to exhibit a property allowing transmission of light ranging from the red to ultraviolet wavelength, and its excitons have a high binding energy. Thus, if ferromagnetism is given to this compound, the obtained material can also contribute to a major breakthrough in preparing optical devices such as an optical quantum computer utilizing coherent spin dynamics.

There has not been known any case achieving a ferromagnetic state by doping a transition metal into a Group III-V nitride. In Group III-V nitride, it has not been reported to achieve a ferromagnetic state having a high ferromagnetic transition temperature (Currie point) of room temperature or more.

As mentioned above, if a material having stable ferromagnetic characteristics is obtained using Group II-VI or III-V compounds, the obtained material can be widely used for the development of magnetooptic-spin devices utilizing a magnetooptic effect, for example, by combining it with a light-emitting element, such as a semiconductor laser, made of a Group II-VI or III-V compound with excitons having a high binding energy, or arranging it to generate circularly-polarized light depending on its magnetic state.

When the above material is used to provide a ferromagnetic-memory in such a manner that light is irradiated thereon to change its magnetization state, it should be prepared to have desired ferromagnetic characteristics, for example, to have a ferromagnetic transition temperature (Currie temperature) arranged at a value (a temperature slightly higher that room temperature) allowing the magnetization state to be changed in response to the light irradiation.

In view of the above circumstances, it is therefore an object of the present invention to provide a single-crystal material prepared by using a Group II-VI or III-V compound to exhibit ferromagnetism.

It is another object of the present invention to provide a method of adjusting ferromagnetic characteristics, such as ferromagnetic transition temperature, of the Group II-VI or III-V compound-based single-crystal ferromagnetic material.

### DISCLOSURE OF THE INVENTION

Through various researches for obtaining a single crystal having ferromagnetic characteristics by using Group II-VI compounds particularly suitable as a light-transmittable material, the inventers found that a transition metal element, such as Ti, V, Cr, Mn, Fe, Co, Ni, Cu, Rh or Ru, has an ion radius close to that of Zn or Cd, and thus a Group II-VI compound can be adequately formed as a single crystal even if about 50 at % of Zn or Cd in the Group II-VI compound is substituted with the transition metal element, and particularly that the single crystal can be formed in a stable ferromagnetic state by adding either one of transition metal elements V and Cr to a Group II-VI compound to form a mixed crystal, so as to allow d-electrons or d-holes to wander about the crystal, or by additionally doping a carrier into a Group II-VI compound.

The inventors also found that the transition metal element V, Cr and another transition metal element such as Mn, go into a high spin state having an electron spin s = 3/2, 4/2, 5/2, and a Group II-VI compound-based single-crystal ferromagnetic material having desired ferromagnetic characteristics can be obtained by adjusting the concentration or mixing rate of these transition metal elements.

Further, through various researches for obtaining a single crystal having ferromagnetic characteristics by using a Group III-V non-nitride selected from the group consisting of GaAs, InAs, InP and GaP, which is particularly suitable as a material allowing transmittance of light ranging from the red to far-infrared wavelength, the inventors found: that a transition metal element, such as Ti, V, Cr, Mn, Fe, Co, Ni, Cu, Rh or Ru, has an ion radius close to that of Ga or In, and thus the Group III-V non-nitride can be adequately formed as a single crystal even if about 25 at % of Ga or In in the Group III-V non-nitride is substituted with the transition metal element; that a single crystal with ferromagnetism can be obtained by adding Mn to the Group II-VI non-nitride semiconductor to form a mixed crystal, which can dope holes more than the electron state of Mn (five d-electrons); and that an effect equivalent to that from the addition of Mn or holes in a high concentration can be obtained by adding a transition metal element, such as Cr or V, in which d-electrons are more reduced as compared to Mn, to the Group III-V non-nitride to form a mixed crystal. Based on this knowledge, the inventers verified that the single crystal can be obtained in a stable ferromagnetic state having a drastically higher Currie point than that from the conventional Mn doping, only by adding the transition metal element, such as V or Cr, to the Group III-V non-nitride, so as to form a mixed crystal of the transition metal element with the Group III-V non-nitride.

The inventors also found that the transition metal elements such as V, Cr and Mn go into a high spin state having an electron spin s = 1, 3/2, 2, and a Group III-V non-nitride-based single-crystal ferromagnetic material having desired ferromagnetic characteristics can be obtained by adjusting the concentration or mixing rate of these transition metal elements.

Furthermore, through various researches for obtaining a single crystal having ferromagnetic characteristics by using a Group III-V nitride particularly suitable as a light-transmittable material, the inventors found: that the Group III-V nitride can be adequately formed as a single crystal even if about 25 at % of Ga or Al in the Group III-V nitride is substituted (mixed-crystallized) with a transition metal element, such as V, Cr or Mn, at a low temperature through a non-equilibrium crystal growth method; that a single crystal with ferromagnetism can be obtained by adding V, Cr or Mn to the Group III-V nitride semiconductor to form a mixed crystal, so as to dope holes or electrons (increase/reduce electrons) depending on change in the electron state of V, Cr or Mn; and that an effect equivalent to that from the addition of holes to d-electrons can be obtained by adding the transition metal element, such as V, Cr or Mn, to the Group III-V nitride, to form a mixed crystal. Based on this knowledge, the inventers verified that the single crystal can be obtained in a stable ferromagnetic state by adding the transition metal element, such as V, Cr or Mn, to the Group III-V nitride, so as to form a mixed crystal of the transition metal element with the Group III-V nitride.

The inventors also found that the transition metal elements such as V, Cr and Mn go into a high spin state having an electron spin s = 1, 3/2, 2, and a Group III-V nitride-based single-crystal ferromagnetic material having desired ferromagnetic characteristics can be obtained by adjusting the concentration or mixing rate of these transition metal elements.

More specifically, it has been found: that the Group III-V compound-based single-crystal ferromagnetic material can be obtained with different ferromagnetic transition temperatures, or in a stabilized ferromagnetic state more than an antiferromagnetic or paramagnetic state, or with an adjustable energy in the ferromagnetic state (for example, an energy such that while an antiferromagnetic state is caused by a narrow margin, it can normally maintain the ferromagnetic state), by changing the concentration of transition metal elements, or forming a mixed crystal with two or more kinds of the transition metal elements in combination or with different ratios of these transition metal elements, or additionally adding n-type and/or p-type dopants; and that the Group III-V compound-based single-crystal ferromagnetic material can have a desired filter function by selectively adding two or more kinds of the transition metal elements to form a mixed crystal, because each of the transition metal elements has a different minimum transmittable wavelength.

According the present invention, there is provided a method of adjusting the ferromagnetic characteristic of a Group II-VI or III-V compound-based single-crystal ferromagnetic material, comprising:
adding (I) at least one transition metal element selected from the group consisting of V and Cr, or
(2) the transition metal element set forth in (1), and at least one transition metal element selected from the group consisting of Ti, Mn, Fe, Co, Ni, Cu, Rh and Ru, or
(3) the one or more transition metal elements set forth in (1) or (2), and at least one of an n-type dopant and a p-type dopant,
to a Group II-VI compound selected from the group consisting of ZnTe, ZnSe, ZnS, CdTe, CdSe and CdS, or to a Group III-V compound selected from the group consisting of GsAs, InAs, InP and GaP; and
controlling the concentration of the one or more elements set forth in either one of (1), (2) and (3), so as to adjust the ferromagnetic transition temperature and/or another ferromagnetic characteristic of the Group II-VI or III-V compound-based single-crystal ferromagnetic material.

The present invention also provides a method of adjusting the ferromagnetic characteristic of a Group II-VI or III-V compound-based single-crystal ferromagnetic material, comprising:
adding (1) at least one transition metal element selected from the group consisting of V and Cr, or
(2) the transition metal element set forth in (1), and at least one transition metal element selected from the group consisting of Ti, Mn, Fe, Co, Ni, Cu, Rh and Ru,
to a Group II-VI compound selected from the group consisting of ZnTe, ZnSe, ZnS, CdTe, CdSe and CdS, or to a Group III-V compound selected from the group consisting of GsAs, InAs, InP and GaP; and
adjusting the ferromagnetic transition temperature and/or another ferromagnetic characteristic of the Group II-VI or III-V compound-based single-crystal ferromagnetic material, according to the combination of the elements to be added.

According to the present invention, there is provided a method of adjusting the ferromagnetic characteristic of a Group III-V compound-based single-crystal ferromagnetic material, comprising:
adding (1) at least one transition metal element selected from the group consisting of V, Cr and Mn, or
(2) the transition metal element set forth in (1), and at least one transition metal element selected from the group consisting of Ti, Fe, Co, Ni, Cu, Rh and Ru, or
(3) the one or more transition metal elements set forth in (1) or (2), and at least one of an n-type dopant and a p-type dopant,
to a Group III-V compound selected from the group consisting of GaN, AlN, InN and BN; and
controlling the concentration of the one or more elements set forth in either one of (1), (2) and (3), so as to adjust the ferromagnetic transition temperature and/or another ferromagnetic characteristic of the Group III-V compound-based single-crystal ferromagnetic material.

The present invention also provides a method of adjusting the ferromagnetic characteristic of a Group III-V compound-based single-crystal ferromagnetic material, comprising:
adding (I) at least one transition metal element selected from the group consisting of V, Cr and Mn, or
(2) the transition metal elements set forth in (1), and at least one transition metal element selected from the group consisting of Ti, Fe, Co, Ni, Cu, Rh and Ru,
to a Group III-V compound selected from the group consisting of GaN, AlN, InN and BN; and
adjusting the ferromagnetic transition temperature and/or another ferromagnetic characteristic of the Group III-V compound-based single-crystal ferromagnetic material, according to the combination of the elements to be added.

Each of the above methods may includes forming a mixed crystal of the transition metal elements set forth in (2), to adjust the energy of a ferromagnetic state, and to reduce the entire energy by the kinetic energy of holes or electrons introduced from the metal elements themselves, so as to stabilize the ferromagnetic state.

Each of the above methods may also includes forming a mixed crystal of the transition metal elements set forth in (2), to control the magnitude and sign of the magnetic interaction between the metal atoms by holes or electrons introduced from the metal elements themselves, so as to stabilize a ferromagnetic state.

Further, each of the above methods may includes forming a mixed crystal of the transition metal elements set forth in (2), to control the magnitude and sign of the magnetic interaction between the metal atoms by holes or electrons introduced from the metal elements themselves, and control a light-transmission characteristic based on the mixed crystal of the metal elements so as to provide a desired optical filter characteristic to the material.

In each of the above materials, even if at least one of an n-type and a p-type dopant is doped, the dopant will enters in the matrix of the Group II-VI compound or the Group III-V compound. Thus, while the action of the dopant is not so direct as that between the transition metal elements, the dopant acts on d-electrodes close to the Group II-VI compound or the Group III-V compound to vary holes or electrons so as to allow the ferromagnetic characteristics to be adjusted.

### BRIEF DESCRIPTION OF THE DRAWINGS

FIG. 1 is an explanatory view of one example of an apparatus for forming a Group II-VI compound-based ferromagnetic thin film of the present invention.
FIG. 2 is a diagram showing the difference ΔE between the entire energy of an antiferromagnetic material and the entire energy of a ferromagnetic material when a transition metal such as V or Cr is crystallized in ZnTe.
FIG. 3 is a diagram showing a ferromagnetic transition temperature and the change of a magnetic moment depending on change in the concentration of a transition metal to be crystallized in ZnTe.
FIG 4 is an explanatory diagram of the change of a ferromagnetic transition temperature depending on the ratio of two or more transition metal elements crystallized together.
FIG. 5 is an explanatory diagram showing the change of magnetic state when n-type and p-type dopants using Cr as an example are added.
FIG. 6 is a diagram showing the electron state density of V in ZnTe in a half-metallic (an upward spin means a metal state, and a downward spin means semiconductor) state.
FIG. 7 is a diagram showing the electron state density of Cr in ZnTe in a half-metallic (an upward spin means a metal state, and a downward spin means a semiconductor) state.

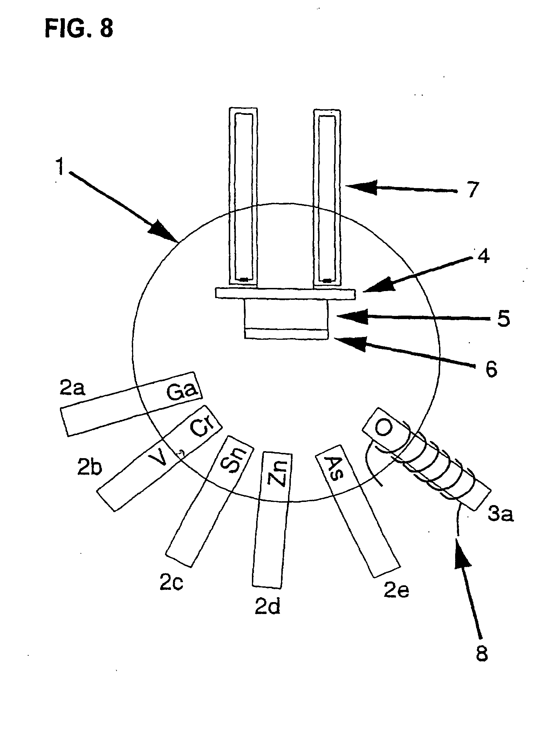

FIG. 8 is an explanatory view of one example of an apparatus for forming a Group III-V non-nitride-based ferromagnetic thin film of the present invention.
FIG 9 is a diagram showing the difference ΔE between the entire energy of an antiferromagnetic spin glass state and the entire energy of a ferromagnetic state when a transition metal such as V or Cr is crystallized in GaAs.
FIG 10 is a diagram showing a ferromagnetic transition temperature depending on change in the concentration of a transition metal to be crystallized in GaAs.
FIG 11 is an explanatory diagram of the change of a ferromagnetic transition temperature depending on the ratio of two or more transition metal elements crystallized together.
FIG 12 is an explanatory diagram showing the change of magnetic state when n-type and p-type dopants using Cr as an example are added.
FIG 13 is a diagram showing the electron state density of V in GaAs in a half-metallic (an upward spin means metal, and a downward spin means semiconductor) state.
FIG 14 is a diagram showing the electron state density of Cr in GaAs in a half-metallic (an upward spin means metal, and a downward spin means semiconductor) state.
FIG. 15 is an explanatory view of one example of an apparatus for forming a Group III-V nitride-based ferromagnetic thin film of the present invention.
FIG 16 is a diagram showing the difference ΔE between the entire energy of an antiferromagnetic spin glass state and the entire energy of a ferromagnetic state when a transition metal such as V, Cr or Mn is crystallized in GaN.
FIG 17 is a diagram showing a ferromagnetic transition temperature depending on change in the concentration of a transition metal to be crystallized in GaN.
FIG. 18 is an explanatory diagram of the change of a ferromagnetic transition temperature depending on the ratio of two or more transition metal elements crystallized together.
FIG. 19 is an explanatory diagram showing the change of magnetic state when n-type and p-type dopants using Cr as an example are added.
FIG 20 is a diagram showing the electron state density of V in GaN in a half-metallic (an upward spin means metal, and a downward spin means semiconductor) state.
FIG. 21 is a diagram showing the electron state density of Cr in GaN in a half-metallic (an upward spin means metal, and a downward spin means semiconductor) state.

### DESCRIPTION OF THE PREFERRED EMBODIMENT

With reference to the drawing, a single-crystal ferromagnetic material and a method of adjusting its ferromagnetic characteristics will now be described.

In a Group II-VI compound-based ferromagnetic material, at least one transition metal element selected from the group consisting of V and Cr is substituted for the Group II element of a Group II-VI compound to form a mixed crystal. The Group II-VI compound herein means a chalcogen compound including Zn and Cd, and specifically includes ZnS, ZnSe, ZnTe, CdS, CdSe and CdTe. In this structure, the aforementioned transition metal element has an ion radius close to that of a Group II element such as Zn or Cd. Thus, even if about 50 at % or more of Zn or Cd in the Group II-VI compound is substituted with the transition metal element, it can maintain a single crystal having a zinc blende structure, and exhibits a ferromagnetic property in a zinc blende structure while maintaining its transparency.

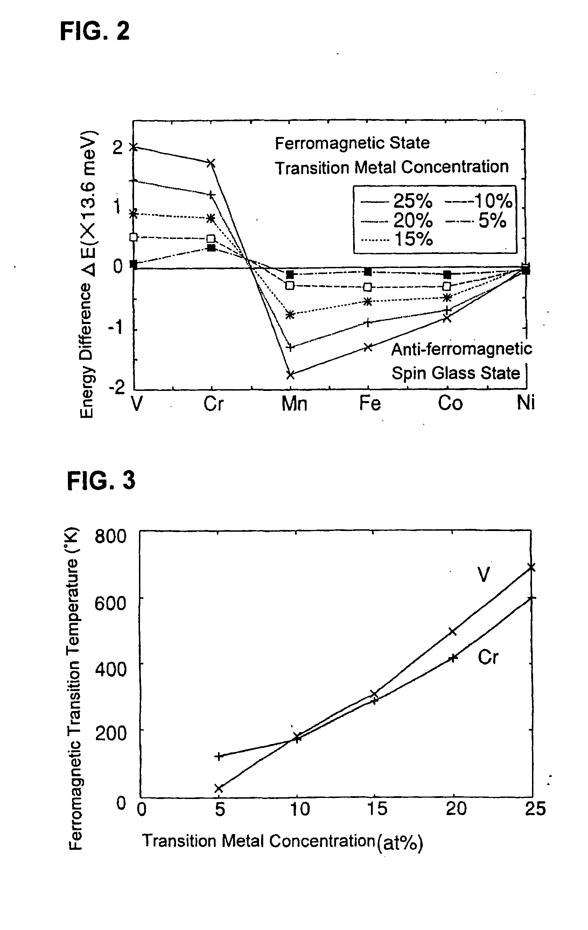

As mentioned above, the inventors have made various researches for obtaining a ferromagnetic material using a Group II-VI compound. Through the researches, the inventors found that the transition metal element V or Cr allows d-electrons to be released therefrom more than Mn exhibiting anti-ferromagnetism by three, and thus, as seen from FIG. 2 showing the difference ΔE between the entire energy of an antiferromagnetic spin glass state and the entire energy of a ferromagnetic state in ZnTe, the mixed crystal can exhibit ferromagnetism only by crystallizing V or Cr in the Group II-VI compound independently.

FIG. 2 shows examples in which the mixed ratio of the crystallized transition metal element to Zn of ZnTe is arranged at 5, 10, 15, 20 and 25 at %. The mixed crystal exhibits ferromagnetism even at the mixed ratio of several %, and the crystallization and transparency are not degraded even if the ratio is increased. Thus, the mixed ratio is can be set in the range of 1 to 99 at %, preferably 5 to 80 at % to provide sufficient ferromagnetism. The kind of the transition metal element is not limited to one, but two or more kinds of transition metal elements may be crystallized together as described later.

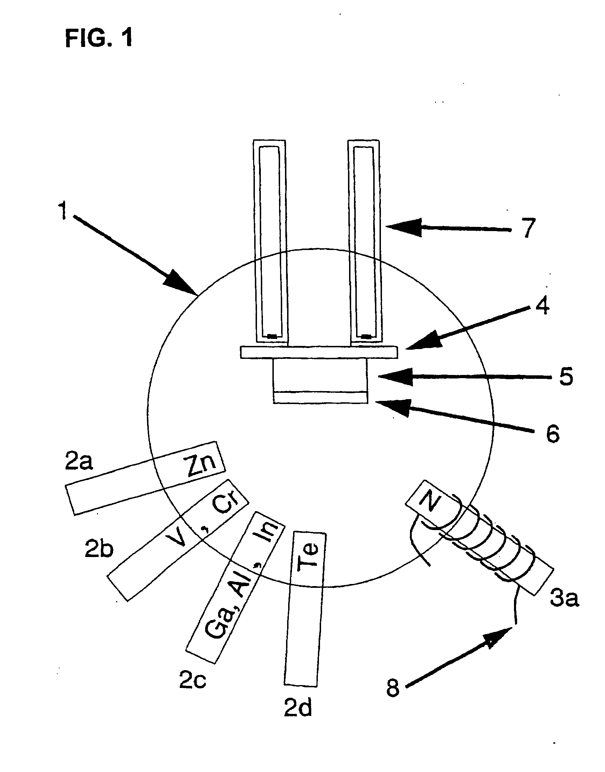

A thin film of the Zn compound containing the above transition metal element can be formed, for example, by using an MBE apparatus as schematically shown in FIG 1. In the MBE apparatus, a substrate 5, such as GaN or sapphire, for growing a ZnTe compound is placed on a substrate holder 4 contained in a chamber 1 capable of maintaining a ultra-high-vacuum of about 1.33 × 10⁻⁶ Pa, and a heater 7 is operable to heat the substrate 5.

The MBE apparatus includes: a cell 2a disposed opposed to the substrate 5 held by the substrate holder 4, and containing Zn as a material (source) of an element constituting a compound to be grown; a cell 2d containing Te; a cell 2b (while Fig. 1 shows only one cell, two or more cells will be provided if two or more transition metal elements are crystallized together) containing a transition metal element such as V or Cr; a cell 2c containing an n-type dopant such as Ga, Al, In, Cl or Br; and an RF radical cell 3a for generating a radical nitrogen N as a p-type dopant. The solid material such as Zn or transition metal may be contained in a cell in the form of its metal oxide, and heated into an atomic form.

Each of the cells 2a to 2d for containing a solid substance (elementary substance) provided with a heating device (not shown) which is operable to heat the cell so as to evaporate the solid substance into an atomic form, and the radical cell 3a is configured to be activated by an RF (radio frequency wave) coil 8, as shown in FIG 1.

Each of the materials of Zn, transition metal element and n-type dopant is prepared by atomizing a solid source having a purity of 99.99999 %. N+ or N₂ in an excited state is prepared by activating a N₂ molecule or N₂O using the above radical cell. Ga, Al, In or transition metal element can be atomized by irradiating thire molecular gas with an electromagnetic wave in a microwave range.

The n-type dopant of Ga, Al or In, the p-type dopant of atomic N, and, for example, an atomic transition element of V or Cr are simultaneously supplied on the substrate 5, respectively, at a flow rate of 1.33 × 10⁻⁵ Pa, 6.65 × 10⁻⁵ Pa, and 1.33 × 10⁻⁵ Pa, while growing ZnTe at 350 to 750°C to form a film. In this way, a Zn Te thin film 6 with V or Cr crystallized therein can be obtained.

An example of doping the n-type and p-type dopants has been described as above. FIG 2 and after-mentioned Tables 1 and 2 show an example of doping only V or Cr without doping any dopant.

As shown in FIG. 2, in the ZnTe thin film 6 with V or Cr crystallized therein, the difference ΔE between the entire energy of an antiferromagnetic spin glass state and the entire energy of a ferromagnetic state is 16 × 13.6 meV in V and 15 × 13.6 meV in Cr, to provide ferromagnetism.

The data in FIG 2 is obtained through a first principle calculation (simulation using an atomic number as an input parameter), and the dependency on the concentration of each of the transition metal elements is shown therein. Mn, Fe, Co or Ni will be an anti-ferromagnetic spin glass.

While the transition metal element is doped in the ZnTe compound in the above example, a ZnTe-based compound in which a part of Zn in ZnTe is substituted with another Group II element such as Mg or Cd has a similar structure to that of ZnTe except for its bandgap is variable, and the magnitude of the bandgap can be controlled. Thus, the ZnTe-based compound can also provide a ferromagnetic single-crystal in the same way.

In the ZnTe-based ferromagnetic material of the present invention, the transition metal element having approximately the same ion radius as that of Zn is mixed-crystallized, and thus Zn ²⁺ is substituted with V ²⁺ or Cr ²⁺ to maintain the zinc blende structure.

In addition, V or Cr has an electron structure allowing d-electrons to be reduced more than that of Mn, and a ferromagnetic state can be maintained as it is, as shown in FIG 1. Further, the ferromagnetic ZnTe had a large magnetic moment, and can provide Cr-contained ZnTe-based compound material, for example a magnetic moment of 4.01 × 9.274 J/T (4.01 µB (Bohr magneton)) which is greater than that of elemental Fe (magnetic moment of 2 × 9.274 J/T (2 µB (Bohr magneton)) as shown in after-mentioned Tables 1 and 2. The ZnTe-based compound material provides a ferromagnetic magnet having extremely strong magnetism.

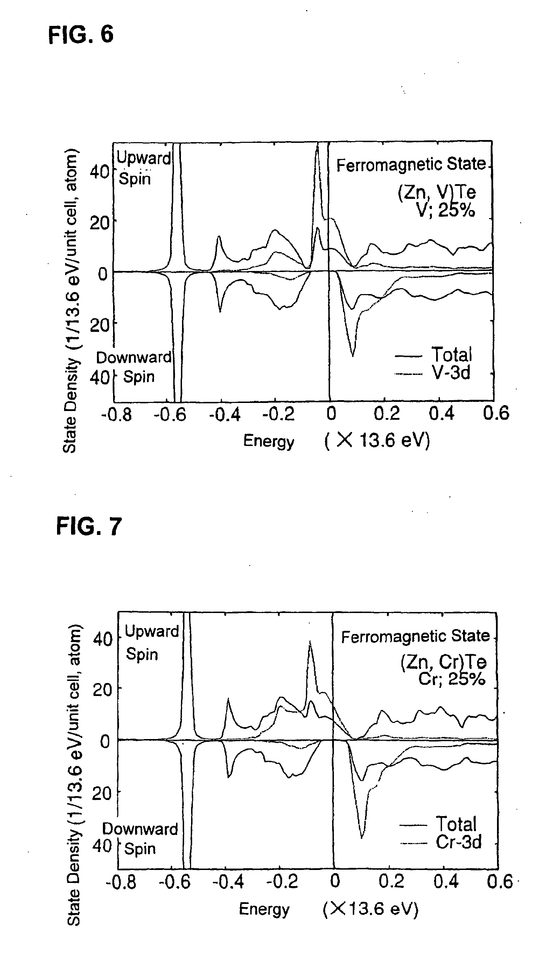

FIG 6 shows the electron state density of V in ZnTe in a half-metallic (an upward spin means a metal state, and a downward spin means semiconductor) state. FIG. 7 shows the electron state density of Cr in ZnTe in a half-metallic (an upward spin means a metal state, and a downward spin means a semiconductor) state.

Then, the change of magnetic characteristic depending on change in the concentration of V or Cr was checked. In addition to the above thin film having the concentration of 25 at%, films having a concentration of 5, 10, 15 and 20 at% are prepared, and respective magnetic moments (× 9.247 J/T) and ferromagnetic transition temperatures (°K) were checked. The magnetic moment and the ferromagnetic transition temperature were obtained from the measurement of magnetization ratio using SQUID (superconducting quantum interference device).

The result is shown in Tables 1 and 2. From Tables 1 and 2, the ferromagnetic transition temperature is apt to be increased as the mixed ratio (or concentration) becomes higher, and increased approximately in proportion to the mixed ratio. This relationship is shown in FIG 3. The ferromagnetic interaction between spins is also increased as the concentration becomes higher.

**(Table 1)**

| Kind of Transition Metal | Concentration of Transition Metal (at %) | Magnetic Moment (µB) | Ferromagnetic Transition Temperature |
|---|---|---|---|
| V | 5 | 3.06 | 30 |
| Cr | 5 | 4.16 | 120 |

**(Table 2)**

| Kind of Transition Metal | Concentration of Transition Metal (at %) | Magnetic Moment (µB) | Ferromagnetic Transition Temperature |
|---|---|---|---|
| V | 25 | 3.00 | 700 |
| Cr | 25 | 4.01 | 600 |

As mentioned above, V or Cr goes in a high spin state having an electron spin s = 3/2, 4/2. As seen from these Tables 1 and 2, and FIG 3, the ferromagnetic interaction between spins and the ferromagnetic transition temperature can be controllably adjusted by changing the concentration of V or Cr. From a practical standpoint, the ferromagnetic transition temperature is preferably adjusted to be 300°K or more.

Further, the inventors found that at least one of V and Cr and different one or more anti-ferromagnetic transition metal elements can be mixed-crystallized to adjust the state of hole or electron, and have the respective magnetic characteristics.

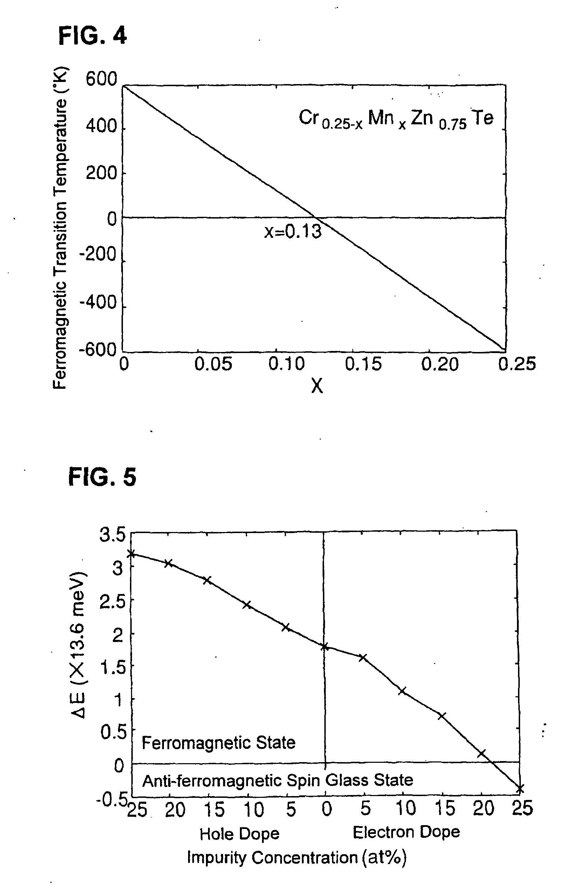

For example, the transition metal of V or Cr, and Mn having anti-ferromagnetism were mixed-crystallized. The total concentration of V and Mn, or Cr and Mn was set at 25 at%, and "x" in Cr_{0.25-x}MnₓZn_{0.75} Te was variously changed. The result is shown in FIG 4. As seen from this figure, the ferromagnetic transition temperature can be largely changed, for example, 0°K when x =0.13, and a desired ferromagnetic transition temperature can be selectively arranged within x = 0 to 0.13.

In the same way, V and Mn can be mixed-crystallized at the concentration of 25 at%, and "x" in V_{0.25-x}MnₓZn_{0.75} Te can be variously changed. While not illustrated, a magnetic moment can be obtained depending on the ratio of V to Mn.

While the ferromagnetic characteristics in the above example have been changed by doping at least one of V and Cr and one or more anti-ferromagnetic transition metal elements, an n-type or p-type dopant may be doped, and the amount of hole or electron can also be changed to change the ferromagnetic state.

In this case, the n-type or p-type dopant enters in the conductive band or valence band of ZnTe, and acts on d-electrons of the transition metal element close to the band. Thus, while the doped dopant is not effective in its entirety, it acts on d-electrons to change the ferromagnetic state and the ferromagnetic transition temperature.

For example, the doping of the n-type dopant is equivalent to supply of an electron. Thus, the above effect from adding V or Cr, and Mn can also be achieved by doping the n-type dopant while crystallizing V or Cr. Further, the doping of the p-type dopant together with Cr can obtain the same effect as that from the addition of V to Cr as described above.

For example, in a case where Cr having a significant change in ΔE = (the entire energy of an antiferromagnetic spin glass state) - (the entire energy of a ferromagnetic state) in response to the doping of the n-type dopant or the p-type dopant (electron or hole) is mixed-crystallized in ZnTe, the relationship between ΔE and the concentration (at %) of doped impurity is shown in FIG. 5.

In this way, since ferromagnetism is stabilized by introducing a hole, and is vanished by doping an electron, the ferromagnetic characteristic can be adjusted. While the transition metal element such as V does not have such a significant change to the anti-ferromagnetic spin glass state, because it originally exhibits ferromagnetism, it can change the ferromagnetic state and ferromagnetic transition temperature in the same level.

Differently from the adjustment according to the aforementioned mixed-crystallization of transition metal, in the adjustment according to this dopant, the magnetic moment itself is maintained at a value determined by the kind of transition material crystallized in ZnTe.

The n-type dopant may include B, Al, In, Ga, Zn or Cl, Br or H, and a chalcogen compound thereof may be used as the material of the dopant. Preferably, a donor concentration is 1 × 10¹⁸ cm ⁻³ or more. For example, the doping at about 10²⁰ to 10 ²¹ cm ⁻³ is equivalent to the aforementioned mixed ratio of about 1 to 10 %.

The p-type dopant may include an atomic N or N⁺ or excited N², as described above. In this case, while the p-type dopant involves the difficulty in doping, a small amount of the n-type dopant can be simultaneously doped to increase the concentration of the p-type dopant.

Through various researches, the inventors found that the transmittable minimum wavelength of a Group II-VI compound with the transition metal is varied depending on whether the transition metal is V or Cr, and at least one of V and Cr and one or more different transition materials can be mixed-crystallized to adjust the minimum wavelength of transmittable light while transmittance or refraction as light-transmittance characteristics is not so changed, so as to form a light filter for cutting light of less than a desired wavelength.

Specifically, the present invention provides a Group II-VI compound-based ferromagnetic material capable of transmitting light having a desired wavelength. When V or Cr is crystallized in ZnTe at 25 at%, the minimum wavelength of transmittable light was measured as show in Table 3.

**(Table 3)**

| Kind of Transition metal | Concentration of Transition Metal (at %) | Minimum Wavelength (nm) |
|---|---|---|
| ZnTe: V | 25 | 495 |
| ZnTe: Cr | 25 | 562 |

That is, according to this example, a ferromagnetic magnet transparent to light having a desired wavelength can be obtained.

In a Group III-V non-nitride-based single-crystal ferromagnetic material of the present invention, at least one transition metal selected from the group consisting of V and Cr is substituted for the Group III element of a Group III-V compound. The Group III-V non-nitride herein means an arsenic compound or phosphorus compound including Ga or In, and specifically GsAs, InAs, GaP and InP. In this structure, the aforementioned transition metal element has an ion radius close to that of a Group III element such as Ga or In. Thus, even if about 25 at % or more of Ga or In in the Group III-V compound is substituted with the transition metal element, it can maintain a single crystal having a zinc blende structure, and exhibits a ferromagnetic property in a zinc blende structure while maintaining its transparency to light ranging from the red to far-infrared wavelength.

The Group III-V non-nitride-based single-crystal ferromagnetic material may include the above transition metal element, and at least one metal element selected from the group consisting of Ti, Mn, Fe, Co, Ni, Cu, Rh and Ru. In this case, each of the metal elements has a different state of d-electron, and thus ferromagnetic characteristics are more directly changed as compared to the doping of hole or electron to allow ferromagnetic characteristics such as a ferromagnetic transition temperature to be adjusted.

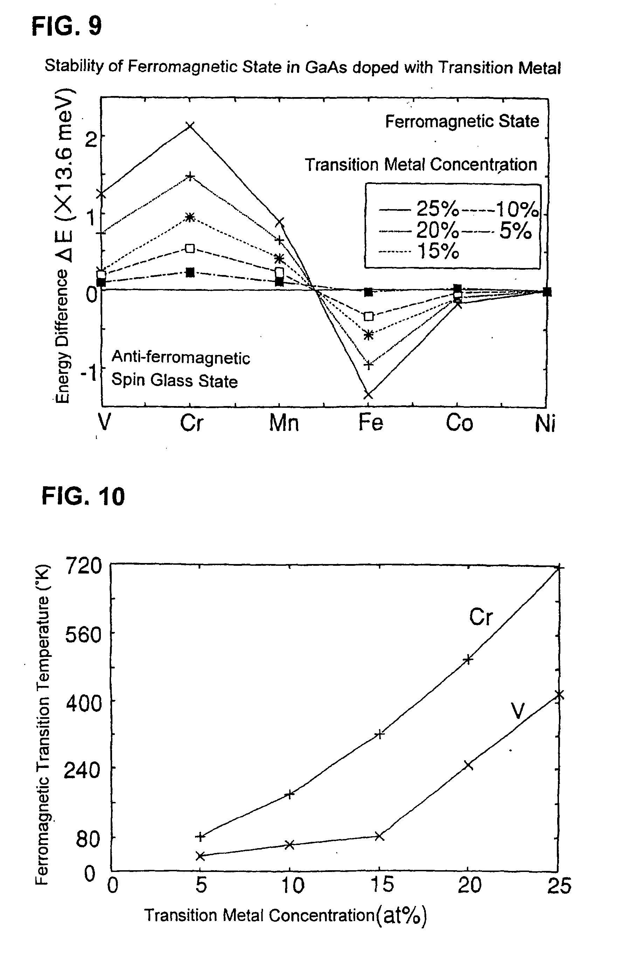

As mentioned above, the inventors have made various researches for obtaining a ferromagnetic material using a Group III-V compound. Through the researches, the inventors found that the transition metal element V or Cr allows d-electrons to be released therefrom more than Fe exhibiting anti-ferromagnetism by three, and thus, as seen from FIG 9 showing the difference ΔE between the entire energy of an antiferromagnetic spin glass state and the entire energy of a ferromagnetic state in GaAs, the mixed crystal can exhibit ferromagnetism only by crystallizing V or Cr in the Group III-V compound independently.

FIG 9 shows examples in which the mixed ratio of the crystallized transition metal element to Ga of GaAs is arranged at 5, 10, 15, 20 and 25 at %. The mixed crystal exhibits ferromagnetism even at the mixed ratio of several %, and the crystallization and transparency are not degraded even if the ratio is increased. Thus, the mixed ratio is can be set in the range of 1 to 100 at %, preferably 5 to 25 at % to provide sufficient ferromagnetism. The kind of the transition metal element is not limited to one, but two or more kinds of transition metal elements may be crystallized (alloyed) together as described later.

A thin film of the GaAs compound containing the above transition metal element can be formed, for example, by using an MBE apparatus as schematically shown in FIG 9. In the MBE apparatus, a substrate 5, such as sapphire, for growing a GaAs compound is placed on a substrate holder 4 contained in a chamber 1 capable of maintaining a ultra-high-vacuum of about 1.33 × 10⁻⁶ Pa, and a heater 7 is operable to heat the substrate 5.

The MBE apparatus includes: a cell 2a disposed opposed to the substrate 5 held by the substrate holder 4, and containing Ga as a material (source) of an element constituting a compound to be grown; a cell 2b (while Fig. 1 shows only one cell, two or more cells will be provided if two or more transition metal elements are crystallized together) containing a transition metal element such as V or Cr; a cell 2c containing an n-type dopant of Sn; an RF radical cell 3a for generating a radical oxygen O as an n-type dopant; and a cell 2d containing a p-type dopant of Zn. The solid material such as Ga, In or transition metal may be contained in a cell in the form of its metal oxide, and heated into an atomic form.

Each of the materials of Zn, In, transition metal element and n-type dopant is prepared by atomizing a solid source having a purity of 99.99999 %. O⁺ or O₂ in an excited state is prepared by activating an O₂ molecule using the above radical cell. Sn or transition metal element can be atomized by irradiating thire molecular gas with an electromagnetic wave in a microwave range.

The n-type dopant of Sn, the p-type dopant of atomic Zn, and, for example, an atomic transition element of V or Cr are simultaneously supplied on the substrate 5, respectively, at a flow rate of 1.33 × 10⁻⁵ Pa, 6.65 × 10 ⁻⁵ Pa, and 1.33 × 10⁻⁵ Pa, while growing GaAs at 350 to 750°C to form a film. In this way, a GaAs thin film 6 with V or Cr crystallized therein can be obtained.

An example of doping the n-type and p-type dopants has been described as above. FIG 9 and after-mentioned Tables 4 and 5 show an example of doping only V or Cr without doping any dopant.

As shown in FIG 9, in the GaAs thin film with V or Cr crystallized therein, the difference ΔE between the entire energy of an antiferromagnetic spin glass state and the entire energy of a ferromagnetic state is 1.3 × 13.6 meV in V and 2.1 × 13.6 meV in Cr, to provide ferromagnetism.

The data in FIG 9 is obtained through a first principle calculation (simulation using an atomic number as an input parameter), and the dependency on the concentration of each of the transition metal elements is shown therein. Fe, Co or Ni will be an anti-ferromagnetic spin glass.

While the transition metal element is doped in the GaAs compound in the above example, a GaAs-based compound in which a part of Ga in GaAs is substituted with another Group III element such as In or B is different in bandgap, but has a similar structure to that of GaAs. Thus, the GaAs-based compound can also provide a ferromagnetic single-crystal in the same way.

In the GaAs-based ferromagnetic material of the present invention, the transition metal element having approximately the same ion radius as that of Ga is mixed-crystallized, and thus Ga ³⁺ is substituted with V ²⁺ or Cr ²⁺ to maintain the zinc blende structure.

In addition, V or Cr has an electron structure allowing d-electrons to be reduced more than that of Mn, and a ferromagnetic state can be maintained as it is, as shown in FIG 9. Further, the ferromagnetic GaAs had a large magnetic moment, and can provide Cr-contained GaAs-based compound material, for example a magnetic moment of 3.00 × 9.274 J/T (3.00 µB (Bohr magneton)) as shown in after-mentioned Tables 4 and 5. The GaAs-based compound material provides a ferromagnetic magnet having extremely strong magnetism.

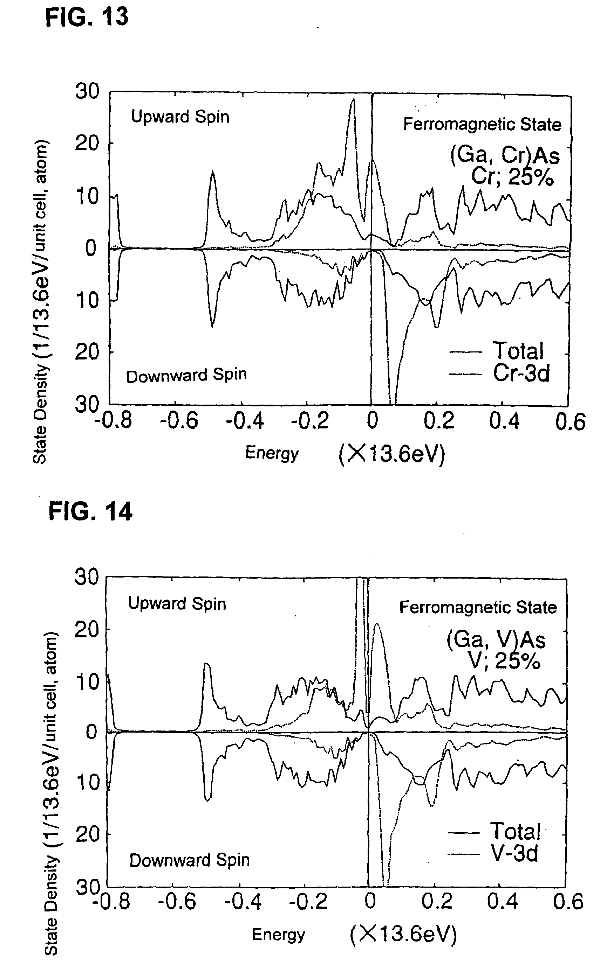

FIG 13 shows the electron state density of V in GaAs in a half-metallic (an upward spin means a metal state, and a downward spin means semiconductor) state. FIG 14 shows the electron state density of Cr in GaAs in a half-metallic (an upward spin means a metal state, and a downward spin means a semiconductor) state.

Then, the change of magnetic characteristic depending on change in the concentration of V or Cr was checked. In addition to the above thin film containing the transition metal element at a concentration of 25 at%, films having a concentration of 5, 10, 15 and 20 at% are prepared, and respective magnetic moments (× 9.247 J/T) and ferromagnetic transition temperatures (°K) were checked. The magnetic moment and the ferromagnetic transition temperature were obtained from the measurement of magnetization ratio using SQUID (superconducting quantum interference device).

The result is shown in Tables 4 and 5. From Tables 4 and 5, the ferromagnetic transition temperature is apt to be increased as the mixed ratio (or concentration) becomes higher, and increased approximately in proportion to the mixed ratio. This relationship is shown in FIG 10. The ferromagnetic interaction between spins is also increased as the concentration of the transition metal element becomes higher.

**(Table 4)**

| Kind of Transition Metal | Concentration of Transition Metal (at %) | Magnetic Moment (µB) | Ferromagnetic Transition Temperature |
|---|---|---|---|
| V | 5 | 2.00 | 35 |
| Cr | 5 | 3.03 | 80 |

**(Table 5)**

| Kind of Transition Metal | Concentration of Transition Metal (at %) | Magnetic Moment (µB) | Ferromagnetic Transition Temperature |
|---|---|---|---|
| V | 25 | 2.00 | 420 |
| Cr | 25 | 3.00 | 720 |

As mentioned above, V or Cr goes in a high spin state having an electron spin s = 1, 3/2, 2. As seen from these Tables 4 and 5, and FIG 10, the ferromagnetic interaction between spins and the ferromagnetic transition temperature can be controllably adjusted by changing the concentration of V or Cr. From a practical standpoint, the ferromagnetic transition temperature is preferably adjusted to be 300°K or more.

Further, the inventors found that at least one of V and Cr and different one or more anti-ferromagnetic transition metal elements can be mixed-crystallized to adjust the state of hole or electron, and have the respective magnetic characteristics.

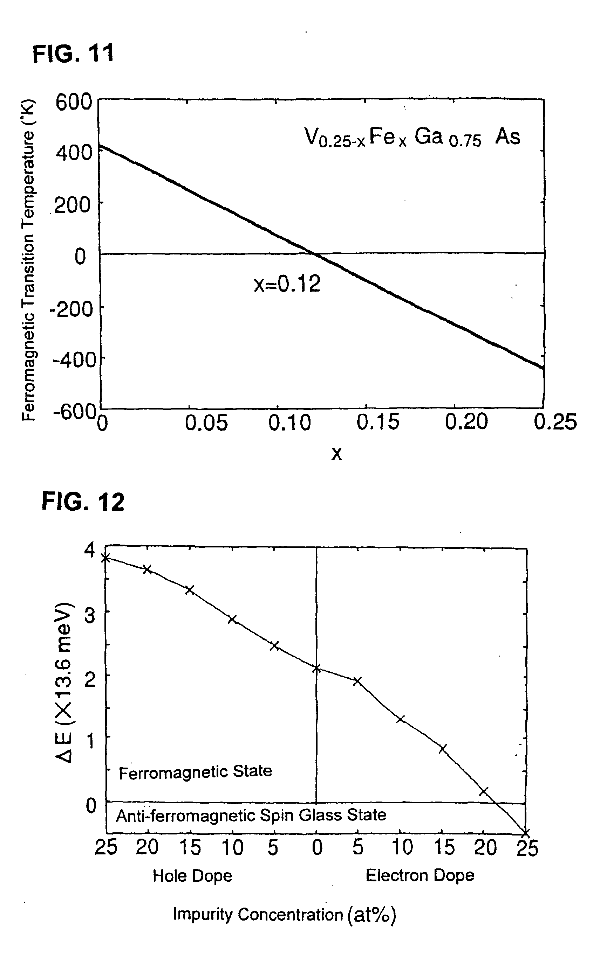

For example, the transition metal of V or Cr, and Fe having anti-ferromagnetism were mixed-crystallized. The total concentration of V and Fe, or Cr and Fe was set at 25 at%, and "x" in Cr _{0.25-x} Feₓ Ga _{0.75} As was variously changed. The result is shown in FIG 11. As seen from this figure, the ferromagnetic transition temperature can be largely changed, for example, 0°K when x =0.12, and a desired ferromagnetic transition temperature can be selectively arranged within x = 0 to 0.12.

In the same way, Cr and Fe can be mixed-crystallized at the total concentration of 25 at%, and "x" in Cr _{0.25-x} Feₓ Ga _{0.75} As can be variously changed. While not illustrated, a magnetic moment can be obtained depending on the ratio of V to Mn.

While the ferromagnetic characteristics in the above example have been changed by doping at least one of V and Cr and one or more anti-ferromagnetic transition metal elements, an n-type or p-type dopant may be doped, and the amount of hole or electron can also be changed to change the ferromagnetic state.

In this case, the n-type or p-type dopant enters in the conductive band or valence band of GaAs, and acts on d-electrons of the transition metal element close to the band. Thus, while the doped dopant is not effective in its entirety, it acts on d-electrons to change the ferromagnetic state and the ferromagnetic transition temperature.

For example, the doping of the n-type dopant is equivalent to supply of an electron. Thus, the above effect from adding V or Cr, and Fe can also be achieved by doping the n-type dopant while crystallizing V or Cr. Further, the doping of the p-type dopant together with Cr can obtain the same effect as that from the addition of V to Cr as described above.

For example, in a case where Cr having a significant change in ΔE = (the entire energy of an antiferromagnetic spin glass state) - (the entire energy of a ferromagnetic state) in response to the doping of the n-type dopant or the p-type dopant (electron or hole) is mixed-crystallized in GaAs, the relationship between ΔE and the concentration (at %) of doped impurity is shown in FIG. 12.

In this way, since ferromagnetism is stabilized by introducing a hole, and is vanished by doping an electron, the ferromagnetic characteristic can be adjusted. While the transition metal element such as V does not have such a significant change to the anti-ferromagnetic spin glass state, because it originally exhibits ferromagnetism, it can change the ferromagnetic state and ferromagnetic transition temperature in the same level.

Differently from the adjustment according to the aforementioned mixed-crystallization of transition metal, in the adjustment according to this dopant, the magnetic moment itself is maintained at a value determined by the kind of transition material crystallized in GaAs.

The n-type dopant may include Sn, Se, S, Te or H, and an oxide thereof may be used as the material of the dopant. Preferably, a donor concentration is 1 × 10¹⁸ cm ⁻³ or more. For example, the doping at about 10 ²⁰ to 10 ²¹ cm ⁻³ is equivalent to the aforementioned mixed ratio of about 1 to 10 %.

The p-type dopant may include an atomic Zn, as described above. In this case, while the p-type dopant involves the difficulty in doping, a small amount of the n-type dopant can be simultaneously doped to increase the concentration of the p-type dopant.

Through various researches, the inventors found that the transmittable minimum wavelength of a Group III-V non-nitride with the transition metal is varied depending on whether the transition metal is V or Cr, and at least one of V and Cr and one or more different transition materials can be mixed-crystallized to adjust the minimum wavelength of transmittable light while transmittance or refraction as light-transmittance characteristics is not so changed, so as to form a light filter for cutting light of less than a desired wavelength.

Specifically, the present invention provides a Group III-V compound-based ferromagnetic material capable of transmitting light having a desired wavelength. When V or Cr is crystallized in GaAs at 25 at%, the minimum wavelength of transmittable light was measured as show in Table 6.

**(Table 6)**

| Kind of Transition metal | Concentration of Transition Metal (at %) | Minimum Wavelength (nm) |
|---|---|---|
| GaAs: V | 25 | 700 |
| GaAs: Cr | 25 | 650 |

That is, according to this example, a ferromagnetic magnet transparent to light having a desired wavelength can be obtained.

In a Group III-V nitride-based single-crystal ferromagnetic material of the present invention, at least one transition metal selected from the group consisting of V, Cr and Mn is substituted for the Group III element of a Group III-V compound. The Group III-V nitride herein means a nitride including Ga, Al, In or B, and specifically GaN, AIN, InN and BN. In this structure, the aforementioned transition metal element has an ion radius relatively close to that of a Group III element such as Ga, Al or In. Thus, even if about 25 at % or more of Ga Al or In in the Group III-V compound is substituted with the transition metal element at a low temperature through a non-equilibrium crystal growth method, it can maintain a single crystal having a wurtzite structure, and exhibits a ferromagnetic property in a wurtzite structure while maintaining its transparency.

The Group III-V nitride-based single-crystal ferromagnetic material may include the above transition metal element, and at least one metal element selected from the group consisting of Ti, Fe, Co, Ni, Cu, Rh and Ru. In this case, each of the metal elements has a different state of d-electron, and thus ferromagnetic characteristics are more directly changed as compared to the doping of hole or electron to allow ferromagnetic characteristics such as a ferromagnetic transition temperature to be adjusted.

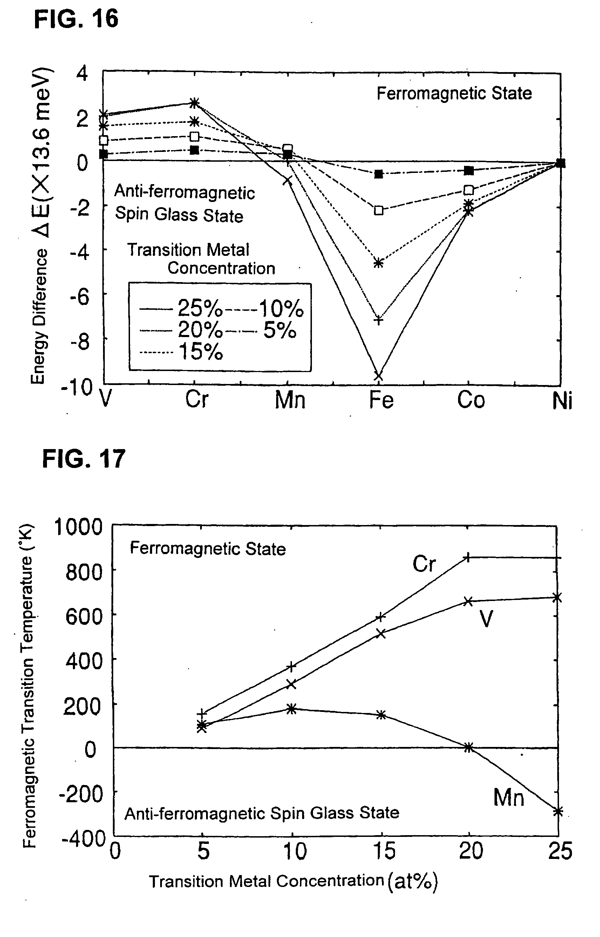

As mentioned above, the inventors have made various researches for obtaining a ferromagnetic material using a Group III-V nitride. Through the researches, the inventors found that the transition metal element V, Cr or Mn allows d-electrons to be released therefrom more than Fe exhibiting anti-ferromagnetism by three, and thus, as seen from FIG 16 showing the difference ΔE between the entire energy of an antiferromagnetic spin glass state and the entire energy of a ferromagnetic state in GaN, the mixed crystal can exhibit ferromagnetism only by crystallizing V, Cr or Mn in the Group III-V compound independently.

FIG. 16 shows examples in which the mixed ratio of the crystallized transition metal element to Ga of GaN is arranged at 5, 10, 15, 20 and 25 at %. The mixed crystal exhibits ferromagnetism even at the mixed ratio of several %, and the crystallization and transparency are not degraded even if the ratio is increased. Thus, the mixed ratio is can be set in the range of 1 to 100 at %, preferably 5 to 25 at % to provide sufficient ferromagnetism. The kind of the transition metal element is not limited to one, but two or more kinds of transition metal elements may be crystallized (alloyed) together as described later.

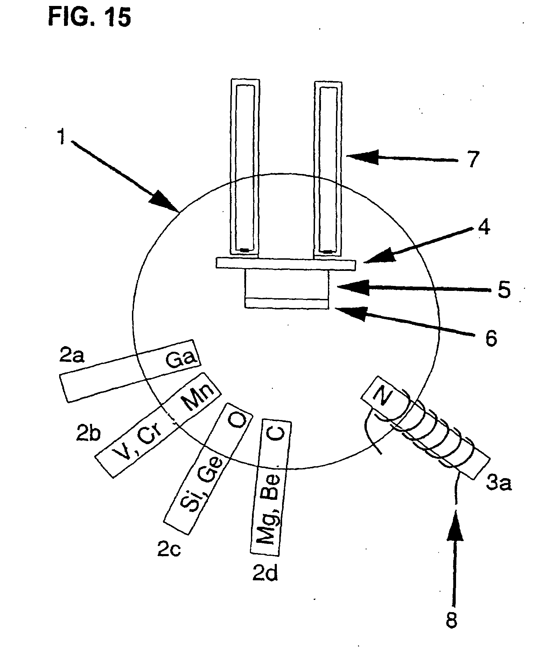

A thin film of the GaN compound containing the above transition metal element can be formed, for example, by using an MBE apparatus as schematically shown in FIG 15. In the MBE apparatus, a substrate 5, such as SIC or sapphire, for growing a GaN compound is placed on a substrate holder 4 contained in a chamber 1 capable of maintaining a ultra-high-vacuum of about 1.33 × 10⁻⁶ Pa, and a heater 7 is operable to heat the substrate 5.

The MBE apparatus includes: a cell 2a disposed opposed to the substrate 5 held by the substrate holder 4, and containing Ga as a material (source) of an element constituting a compound to be grown; a cell 2b (while Fig. 1 shows only one cell, two or more cells will be provided if two or more transition metal elements are crystallized together) containing a transition metal element such as V, Cr or Mn; a cell 2c containing an n-type dopant of Si, Ge or O; a cell 2d containing a p-type dopant of Mg, Be or C; an RF radical cell 3a for generating a radical nitrogen N. The solid material such as Ga or transition metal may be contained in a cell in the form of its metal oxide, and heated into an atomic form.

Each of the materials of Ga, transition metal element and n-type dopant is prepared by atomizing a solid source having a purity of 99.99999 %. N⁺ or N₂ in an excited state is prepared by activating an N₂ molecule or NH₃ using the above radical cell. Ga or transition metal element can be atomized by irradiating thire molecular gas with an electromagnetic wave in a microwave range.

The n-type dopant of Si or O, the p-type dopant of atomic Mg, Be or C, and, for example, an atomic transition element of V, Cr or Mn are simultaneously supplied on the substrate 5, respectively, at a flow rate of 1.33 × 10 ⁻⁵ Pa, 6.65 × 10⁻⁵ Pa, and 1.33 × 10⁻⁵ Pa, while growing GaN at 350 to 800°C to form a film. In this way, a GaAs thin film 6 with V or Cr crystallized therein can be obtained.

An example of doping the n-type and p-type dopants has been described as above. FIG 16 and after-mentioned Tables 7 and 8 show an example of doping only V, Cr or Mn without doping any dopant.

As shown in FIG 16, in the GaN thin film with V, Cr or Mn crystallized therein, the difference ΔE between the entire energy of an antiferromagnetic spin glass state and the entire energy of a ferromagnetic state is 2.04 × 13.6 meV in V, 2.57 × 13.6 meV in Cr and 0.55 ×13.6 meV in Mn, to provide ferromagnetism.

The data in FIG 16 is obtained through a first principle calculation (simulation using an atomic number as an input parameter), and the dependency on the concentration of each of the transition metal elements is shown therein. Fe, Co or Ni will be an anti-ferromagnetic spin glass.

The transition metal element is doped in the GaN compound in the above example. However, in a GaN-based compound in which a part of Ga in GaN is substituted with another Group III element such as Al or B, the magnitude of its bandgap can be controlled, and the structure is the same as that of GaN except for the bandgap. Thus, the GaN-based compound can also provide a ferromagnetic single-crystal in the same way.

In the GaN-based ferromagnetic material of the present invention, the transition metal element having approximately the same ion radius as that of Ga is mixed-crystallized, and thus Ga ³⁺ is substituted with V ²⁺, Cr ²⁺ or Mn ²⁺ to maintain the wurtzite structure.

In addition, V, Cr or Mn has an electron structure allowing holes to be increased, and a ferromagnetic state can be maintained as it is, as shown in FIG. 16. Further, the ferromagnetic GaN had a large magnetic moment, and can provide Cr-contained GaN-based compound material, for example a magnetic moment of 2.94 × 9.274 J/T (2.94 µB (Bohr magneton)) as shown in after-mentioned Tables 7 and 8. The GaN-based compound material provides a ferromagnetic magnet having extremely strong magnetism.

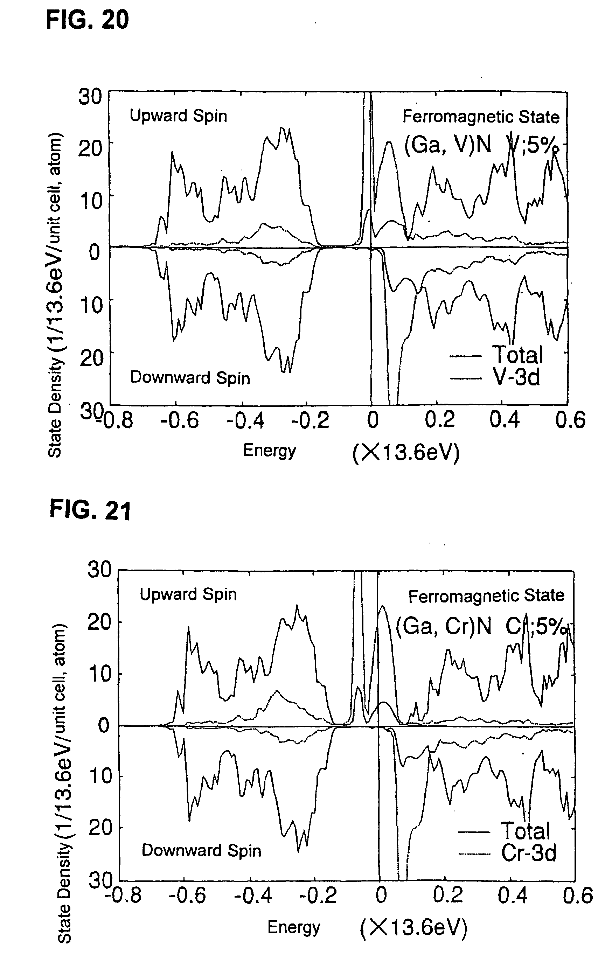

FIG. 20 shows the electron state density of V in GaN in a half-metallic (an upward spin means a metal state, and a downward spin means semiconductor) state. FIG. 21 shows the electron state density of Cr in GaN in a half-metallic (an upward spin means a metal state, and a downward spin means a semiconductor) state.

Then, the change of magnetic characteristic depending on change in the concentration of V, Cr or Mn was checked. In addition to the above thin film containing the transition metal element at a concentration of 25 at%, films having a concentration of 5, 10, 15 and 20 at% are prepared, and respective magnetic moments (× 9.247 J/T) and ferromagnetic transition temperatures (°K) were checked. The magnetic moment and the ferromagnetic transition temperature were obtained from the measurement of magnetization ratio using SQUID (superconducting quantum interference device).

The result is shown in Tables 7 and 8. From Tables 7 and 8, the ferromagnetic transition temperature is apt to be increased as the mixed ratio (or concentration) becomes higher, and increased approximately in proportion to the mixed ratio. This relationship is shown in FIG 17. The ferromagnetic interaction between spins is also increased as the concentration of the transition metal element becomes higher.

**(Table 7)**

| Kind of Transition Metal | Concentration of Transition Metal (at %) | Magnetic Moment (µB) | Ferromagnetic Transition Temperature |
|---|---|---|---|
| V | 5 | 1.05 | 90 |
| Cr | 5 | 2.85 | 160 |
| M | 5 | 4.00 | 110 |

**(Table 8)**

| Kind of Transition Metal | Concentration of Transition Metal (at %) | Magnetic Moment (µB) | Ferromagnetic Transition Temperature |
|---|---|---|---|
| V | 25 | 1.88 | 690 |
| Cr | 25 | 2.94 | 860 |
| Mn | 25 | 3.96 | -280 (anti-ferromagnetism) |

As mentioned above, V, Cr or Mn goes in a high spin state having an electron spin s = 1, 3/2, 2. As seen from these Tables 7 and 8, and FIG 17, the ferromagnetic interaction between spins and the ferromagnetic transition temperature can be controllably adjusted by changing the concentration of V, Cr or Mn. From a practical standpoint, the ferromagnetic transition temperature is preferably adjusted to be 300°K or more.

Further, the inventors found that at least one of V, Cr and Mn and different one or more anti-ferromagnetic transition metal elements can be mixed-crystallized to adjust the state of hole or electron, and have the respective magnetic characteristics.

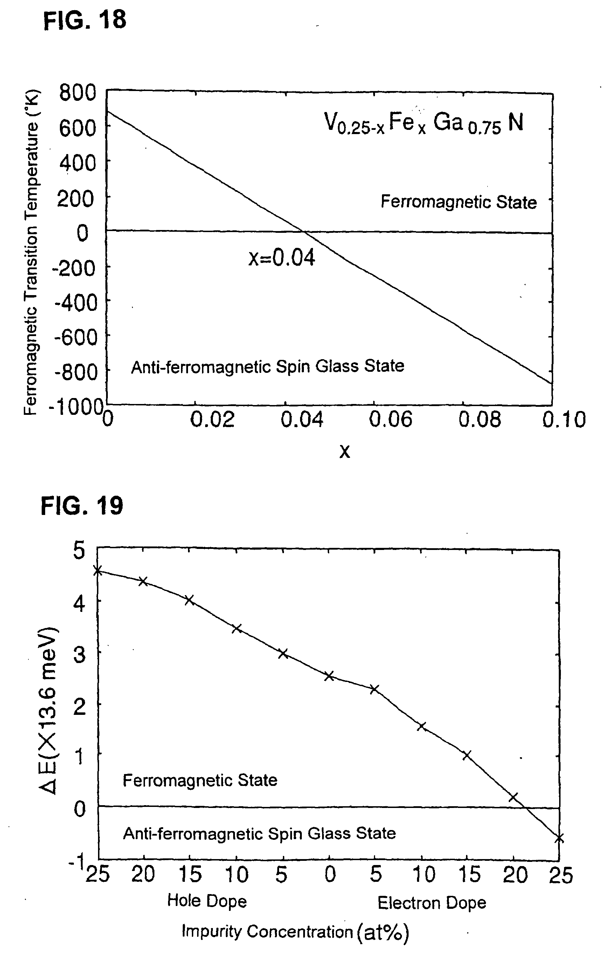

For example, the transition metal of V, Cr or Mn, and Fe having anti-ferromagnetism were mixed-crystallized. The total concentration of V and Fe, or Cr and Fe, or Mn and Fe was set at 25 at%, and "x" in V _{0.25-x} Fe ₓ Ga _{0.75} N was variously changed. The result is shown in FIGS 18. As seen from this figure, the ferromagnetic transition temperature can be largely changed, for example, 0°K when x =0.12, and a desired ferromagnetic transition temperature can be selectively arranged within x = 0 to 0.12.

In the same way, Cr or Mn and Fe can be mixed-crystallized at the total concentration of 25 at%, and "x" in Cr_{0.25-x} Feₓ Ga_{0.75} N, or Mn_{0.25-x} Feₓ Ga_{0.75} N can be variously changed. While not illustrated, a magnetic moment can be obtained depending on the ratio of V to Mn.

While the ferromagnetic characteristics in the above example have been changed by doping at least one of V, Cr and Mn and one or more anti-ferromagnetic transition metal elements, an n-type or p-type dopant may be doped, and the amount of hole or electron can also be changed to change the ferromagnetic state.

In this case, the n-type or p-type dopant enters in the conductive band or valence band of GaN, and acts on d-electrons of the transition metal element close to the band. Thus, while the doped dopant is not effective in its entirety, it acts on d-electrons to change the ferromagnetic state and the ferromagnetic transition temperature.

For example, the doping of the n-type dopant is equivalent to supply of an electron. Thus, the above effect from adding V, Cr or Mn, and Fe can also be achieved by doping the n-type dopant while crystallizing V, Cr or Mn. Further, the doping of the p-type dopant together with Mn can obtain the same effect as that from the addition of Cr to Mn as described above.

For example, in a case where Cr having a significant change in ΔE = (the entire energy of an antiferromagnetic spin glass state) - (the entire energy of a ferromagnetic state) in response to the doping of the n-type dopant or the p-type dopant (electron or hole) is mixed-crystallized in GaN, the relationship between ΔE and the concentration (at %) of doped impurity is shown in FIG 19.

In this way, since ferromagnetism is stabilized by introducing a hole, and is vanished by doping an electron, the ferromagnetic characteristic can be adjusted. While the transition metal element such as V or Mn does not have such a significant change to the anti-ferromagnetic spin glass state, because it originally exhibits ferromagnetism, it can change the ferromagnetic state and ferromagnetic transition temperature in the same level.

Differently from the adjustment according to the aforementioned mixed-crystallization of transition metal, in the adjustment according to this dopant, the magnetic moment itself is maintained at a value determined by the kind of transition material crystallized in GaN.

The n-type dopant may include Sn, Ge or O, and a nitride thereof may be used as the material of the dopant. Preferably, a donor concentration is 1 × 10¹⁸ cm ⁻³ or more. For example, the doping at about 10²⁰ to 10 ²¹ cm ⁻³ is equivalent to the aforementioned mixed ratio of about 1 to 10%.

The p-type dopant may include a Mg, Be or C, as described above. In this case, while the p-type dopant involves the difficulty in doping, a small amount of the n-type dopant can be simultaneously doped to increase the concentration of the p-type dopant.

The inventors found that the transmittable minimum wavelength of a Group III-V nitride with the transition metal is varied depending on whether the transition metal is V, Cr or Mn, and at least one of V, Cr and Mn and one or more different transition materials can be mixed-crystallized to adjust the minimum wavelength of transmittable light while transmittance or refraction as light-transmittance characteristics is not so changed, so as to form a light filter for cutting light of less than a desired wavelength.

Specifically, the present invention provides a Group III-V nitride-based ferromagnetic material capable of transmitting light having a desired wavelength. When V, Cr or Mn is crystallized in GaN at 25 at%, the minimum wavelength of transmittable light was measured as show in Table 9.

**(Table 9)**

| Kind of Transition metal | Concentration of Transition Metal (at %) | Minimum Wavelength (nm) |
|---|---|---|
| GaN: V | 25 | 400 |
| GaN: Cr | 25 | 390 |
| GaN: Mn | 25 | 380 |

That is, according to this example, a ferromagnetic magnet transparent to light having a desired wavelength can be obtained.

As mentioned above, according to the present invention, the kinetic energy of hole or electron introduced a metal element itself to be mixed-crystallized can change the entire energy, and hole or electron to be introduced can be adjusted by reducing the entire energy to provide a stabilized ferromagnetic state

Further, the magnitude and sign of the magnetic interaction between metal atoms are changed depending on hole or electron to be introduced. Thus, the ferromagnetic state can be stabilized by controlling the hole or electron

While an MBE (molecular beam epitaxy) apparatus has been used for forming the Group II-VI or III-V compound thin film in the above example, an MOCVD (metalorganic chemical vapor deposition) apparatus may be used to form the film. In this case, the metal material of Zn, Cd, Ga, In, Al or transition metal is introduced in the MOCVD apparatus, in the form of an organic metal compound such as dimethyl zinc, dimethyl gallium or dimethyl aluminum.

In the MBE apparatus or the MOCVD apparatus, the thin film is formed in a nonequilibrium state to allow the transition metal material to be doped at a desired concentration.

The film forming method is not limited to these methods, but a laser abrasion method may be used in which a film is formed while blowing an activated dopant onto a substrate, using a target, such as a target Zn sulfate (selenide) solid, transition-metal-elemental material or sulfate (selenide) solid, or Ga, In solid, transition-metal-elemental material or compound solid, Ga nitrided solid or Al nitride solid.

Further, when a transition metal material or its chalcogen compound is doped as a material, an ECR plasma for antagonizing an object by electronically exciting with radio waved, leaser, X-ray or electron beam may be used. The ECR plasma may be used in an n-type dopant or a p-type dopant. The ECR makes it possible to form a dopant in an atomic state and dope it in high concentration.

### INDUSTRIAL APPLICABILITY

According to the present invention, a ferromagnetic single crystal can be obtained only by mixing at least one of V and Cr into Group II-VI compound or Group III-V non-nitride, or by mixing at least one of V, Cr or Mn and Mn into Group III-V nitride. Thus, the ferromagnetic single crystal can be combined with a ZnO or transparent conductive oxide (TCO), which is used as an n-type and p-type transparent electrode, or optical fibers, to open the way to realize a quantum computer or a high-capacity magnetooptical recording, and can provide an optical electronics material usable in from visible to ultraviolet range which is applicable to high-performance information communication or a quantum computer.

## Claims

1. A Group II-VI or III-V compound-based single-crystal ferromagnetic material, wherein at least one transition metal selected from the group consisting of V and Cr is substituted for the Group II element of a Group II-VI compound selected from the group consisting of ZnTe, ZnSe, ZnS, CdTe, CdSe and CdS, or for the Group III element of a Group III-V compound selected from the group consisting of GsAs, InAs, InP and GaP, to form a mixed crystal.

2. The single-crystal ferromagnetic material as defined in claim 1, wherein said mixed crystal further contains at least one selected from the group consisting of Ti, Mn, Fe, Co, Ni, Cu, Rh and Ru.

3. A Group III-V compound-based single-crystal ferromagnetic material, wherein at least one transition metal selected from the group consisting of V, Cr and Mn is substituted for the Group III element of a Group III-V compound selected from the group consisting of GaN, AlN, InN and BN, to form a mixed crystal.

4. The single-crystal ferromagnetic material as defined in claim 3, wherein said mixed crystal further contains at least one selected from the group consisting of Ti, Fe, Co, Ni, Cu, Rh and Ru.

5. The single-crystal ferromagnetic material as defined in either one of claims 1 to 4, which is doped with at least one of an n-type dopant and a p-type dopant.

6. A method of adjusting the ferromagnetic characteristic of a Group II-VI or III-V compound-based single-crystal ferromagnetic material, comprising:
adding (1) at least one transition metal element selected from the group consisting of V and Cr, or
(2) said transition metal element set forth in (1), and at least one transition metal element selected from the group consisting of Ti, Mn, Fe, Co, Ni, Cu, Rh and Ru, or
(3) said one or more transition metal elements set forth in (1) or (2), and at least one of an n-type dopant and a p-type dopant,
to a Group II-VI compound selected from the group consisting of ZnTe, ZnSe, ZnS, CdTe, CdSe and CdS, or to a Group III-V compound selected from the group consisting of GsAs, InAs, Wand Gap; and
controlling the concentration of said one or more elements set forth in either one of (1), (2) and (3), so as to adjust the ferromagnetic transition temperature and/or another ferromagnetic characteristic of said Group II-VI or III-V compound-based single-crystal ferromagnetic material.

7. A method of adjusting the ferromagnetic characteristic of a Group II-VI or III-V compound-based single-crystal ferromagnetic material, comprising:
adding (1) at least one transition metal element selected from the group consisting of V and Cr, or
(2) said transition metal element set forth in (1), and at least one transition metal element selected from the group consisting of Ti, Mn, Fe, Co, Ni, Cu, Rh and Ru,
to a Group II-VI compound selected from the group consisting of ZnTe, ZnSe, ZnS, CdTe, CdSe and CdS, or to a Group III-V compound selected from the group consisting of GsAs, InAs, InP and GaP; and
adjusting the ferromagnetic transition temperature and/or another ferromagnetic characteristic of said Group II-VI or III-V compound-based single-crystal ferromagnetic material, according to the combination of said elements to be added.

8. A method of adjusting the ferromagnetic characteristic of a Group III-V compound-based single-crystal ferromagnetic material, comprising:
adding (1) at least one transition metal element selected from the group consisting of V, Cr and Mn, or
(2) said transition metal element set forth in (1), and at least one transition metal element selected from the group consisting of Ti, Fe, Co, Ni, Cu, Rh and Ru, or
(3) said one or more transition metal elements set forth in (1) or (2), and at least one of an n-type dopant and a p-type dopant,
to a Group III-V compound selected from the group consisting of GaN, AlN, InN and BN; and
controlling the concentration of said one or more elements set forth in either one of (1), (2) and (3), so as to adjust the ferromagnetic transition temperature and/or another ferromagnetic characteristic of said Group III-V compound-based single-crystal ferromagnetic material.

9. A method of adjusting the ferromagnetic characteristic of a Group III-V compound-based single-crystal ferromagnetic material, comprising:
adding (1) at least one transition metal element selected from the group consisting of V, Cr and Mn, or
(2) said transition metal elements set forth in (1), and at least one transition metal element selected from the group consisting of Ti, Fe, Co, Ni, Cu, Rh and Ru,
to a Group III-V compound selected from the group consisting of GaN, AlN, InN and BN; and
adjusting the ferromagnetic transition temperature and/or another ferromagnetic characteristic of said Group III-V compound-based single-crystal ferromagnetic material, according to the combination of said elements to be added.

10. The method as defined in either one of claims 6 to 9, which includes forming a mixed crystal of said transition metal elements set forth in (2), to adjust the energy of a ferromagnetic state, and to reduce the entire energy by the kinetic energy of holes or electrons introduced from said metal elements themselves, so as to stabilize the ferromagnetic state.

11. The method as defined in either one of claims 6 to 9, which includes forming a mixed crystal of said transition metal elements set forth in (2), to control the magnitude and sign of the magnetic interaction between the metal atoms by holes or electrons introduced from said metal elements themselves, so as to stabilize a ferromagnetic state.

12. The method as defined in either one of claims 6 to 9, which includes forming a mixed crystal of said transition metal elements set forth in (2), to control the magnitude and sign of the magnetic interaction between the metal atoms by holes or electrons introduced from said metal elements themselves, and control a light-transmission characteristic based on the mixed crystal of said metal elements so as to provide a desired optical filter characteristic to said material.
